# FASCICULE DE BREVET EUROPEEN

(11) **EP 4 020 728 B1**
(45) Date de publication et mention de la délivrance du brevet: **11.01.2023**
(21) Numéro de dépôt: 21203699.0
(22) Date de dépôt: 20.10.2021
(51) Int. Cl.: H02B 13/045

(54) **CUVE POUR APPAREIL ÉLECTRIQUE À MOYENNE TENSION**
BEHÄLTER FÜR ELEKTRISCHES MITTELSPANNUNGSGERÄT
TANK FOR MEDIUM-VOLTAGE ELECTRICAL DEVICE

(30) Priorité: 23.12.2020 FR 2014059
(43) Date de publication de la demande: 29.06.2022
(73) Titulaire: Schneider Electric Industries SAS, 92500 Rueil-Malmaison (FR)
(72) Inventeur: GENTILS, François, 38210 Tullins (FR); BONFILS, Jean-Michel, 38000 Grenoble (FR)
(74) Mandataire: Schneider Electric

(56) Documents cités:
- EP-A1- 3 188 331
- CN-A- 1 876 308
- CN-U- 203 536 845
- CN-U- 206 585 262
- FR-A1- 3 097 383

## Description

### Domaine technique

La présente invention se rapporte au domaine des cuves destinées à contenir des appareils électriques de distribution de moyenne tension, c'est-à-dire des tensions comprises entre 1 et 52 kV. Ces cuves peuvent par exemple contenir des appareils de coupure tels que des interrupteurs, des disjoncteurs ou des sectionneurs, permettant d'assurer le fonctionnement d'un réseau de distribution électrique à moyenne tension.

### Technique antérieure

Une cuve contenant des équipements électriques moyenne tension doit assurer l'isolation électrique des équipements électriques entre eux, ainsi que vis-à-vis de l'extérieur, et ainsi éviter la création d'arcs électriques ainsi que de décharges électriques, également appelées « streamer » en Anglais.

Pour cela, il est courant de remplir la cuve d'un gaz fluoré sous pression, tel l'hexafluorure de soufre, qui présente des propriétés diélectriques satisfaisantes. Cependant, ce gaz présente aussi un fort pouvoir de réchauffement climatique. Il est ainsi possible d'utiliser à la place des gaz présentant un faible potentiel de réchauffement, tel que de l'air, de l'azote ou du dioxyde de carbone. Ces gaz possèdent une plus faible tenue diélectrique que le gaz à remplacer. Pour conserver les mêmes performances en termes d'isolation électrique, la pression du gaz à l'intérieur de l'enceinte doit être plus que doublée.

Les contraintes mécaniques transmises à la structure de la cuve par la pression s'appliquant sur des panneaux de la cuve augmentent sous l'effet de la pression accrue du gaz contenu dans la cuve. Afin d'éviter que cette structure ne se déforme, il convient donc de la renforcer. Une possibilité est d'augmenter l'épaisseur des panneaux et/ou de la structure. Cette solution présente l'inconvénient d'augmenter significativement le prix de revient de la cuve.

Une autre possibilité peut être d'avoir une solide ossature de la structure constituées de montants et ajouter des renforts métalliques reliant entre eux les montants, comme divulgué dans les documents CN203536845U, EP3188331A1, CN1876308A et CN206585262U. Dans ce cas, une difficulté est de garantir l'isolation de ces renforts, et d'éviter la formation d'arc électriques entre les renforts et les appareils électriques contenus dans la cuve.

Pour de tels renforts métalliques, il est connu de les isoler électriquement des éléments sous tension dans la cuve avec un isolant électrique en matière plastique, tel que de l'élastomère, mais cette solution est onéreuse. Il est aussi connu d'isoler électriquement ces renforts métalliques en les surmoulant avec de la résine thermodurcissable. Cependant, des dilatations entraînent des fatigues du matériau isolant et donc des risques de dégradation de l'interface avec le renfort métallique. II est aussi connu d'utiliser tirants en matériau isolant de type thermoplastique or thermodurcissable (FR3097383A1), mais leur résistance mécanique n'est pas optimale.

Il existe ainsi un besoin de fournir une cuve à la résistance mécanique renforcée à base de tiges de renfort métalliques, présentant un surcout moindre, et possédant de meilleures performances d'isolation électrique que les solutions connues de l'art antérieur.

### Résumé

A cette fin, l'invention propose une cuve pour appareil électrique à moyenne tension selon la revendication indépendante 1.

Les tiges de renforts permettent de rigidifier la structure et d'éviter sa déformation sous l'effet de la pression du gaz sous pression qui s'exerce sur les panneaux. En entourant la tige de renfort métallique par un tube isolant, l'isolation de la tige de renfort est améliorée et le risque d'avoir création d'un arc électrique entre la tige de renfort et un appareil électrique disposé dans la cuve est éliminé. La solution proposée permet ainsi d'assurer une résistance mécanique compatible avec les pressions mises en jeu dans la cuve, tout en garantissant une isolation électrique satisfaisante. Le surcout induit est faible et modifie peu le procédé de fabrication de la cuve.

Les caractéristiques listées dans les paragraphes suivant peuvent être mises en oeuvre indépendamment les unes des autres ou selon toutes les combinaisons techniquement possibles , tant qu'elles restent dans l'étendue de protection des revendications.

Le gaz destiné à être contenu dans la cuve peut être un gaz pur, où un mélange gazeux. Le gaz destiné à être contenu dans la cuve peut en particulier être un mélange binaire.

La tige de renfort et le premier tube isolant sont coaxiaux.

Le premier tube isolant est disposé, selon la direction longitudinale, entre les deux montants.

Une surface intérieure du premier tube isolant est séparée de la surface latérale de la tige de renfort par du gaz sous pression.

La tige de renfort et le premier tube isolant sont configurés pour qu'une pression du gaz à l'intérieur du tube isolant soit égale à une pression du gaz à l'extérieur du tube isolant 5.

Le tube isolant n'est ainsi pas soumis à des forces tendant à le déformer.

Le premier tube isolant est rempli d'une mousse isolante.

La tige de renfort est rectiligne.

La tige de renfort est cylindrique.

Le diamètre de la tige de renfort est compris entre 6 et 20 millimètres.

Selon une variante de mise en œuvre, la tige de renfort est une tige filetée.

La tige de renfort est ainsi une fourniture courante, et sa fixation est facilitée.

Le premier tube isolant est cylindrique.

Le premier tube isolant est en polypropylène, ou tout autre matériau isolant électrique thermodurcissable, thermoplastique ou céramique.

Ce matériau procure de bonnes propriétés d'isolation diélectrique.

Un diamètre externe du premier tube isolant est compris entre 10 et 24 millimètres.

Une épaisseur du premier tube isolant est comprise entre 1 et 6 millimètres.

Une longueur du premier tube isolant est supérieure à 80% d'une longueur totale de la tige de renfort.

Selon un mode de réalisation, un rapport entre le diamètre de la tige de renfort et le diamètre externe du premier tube isolant est compris entre 0,1 et 0,6.

Selon un mode de réalisation, la cuve comprend un deuxième tube isolant, et le deuxième tube isolant entoure le premier tube isolant.

Le deuxième tube isolant et le premier tube isolant sont coaxiaux.

Un diamètre externe du deuxième tube isolant est compris entre 14 et 40 millimètres.

Une surface intérieure du deuxième tube isolant est distante d'une surface extérieure du premier tube isolant.

La surface intérieure du deuxième tube isolant est séparée de la surface extérieure du premier tube isolant par une couche de gaz sous pression.

La cuve comporte une entretoise configurée pour maintenir le tube isolant coaxial avec la tige de renfort.

Selon une variante de mise en œuvre, la cuve comporte une entretoise configurée pour maintenir le premier tube isolant coaxial avec la tige de renfort et pour maintenir le deuxième tube isolant coaxial avec la tige de renfort.

L'entretoise comporte un logement débouchant recevant la tige de renfort.

L'entretoise comporte une zone de réception insérée au moins en partie dans le premier tube isolant.

L'entretoise est disposée à une extrémité axiale du premier tube isolant.

L'entretoise est disposée à une extrémité axiale du deuxième tube isolant.

L'entretoise est en forme de bague cylindrique épaulée.

Une extrémité axiale du premier tube isolant est en contact avec un épaulement de l'entretoise.

Une surface interne de la bague épaulée est en contact avec la tige de renfort et une surface externe de la bague est en contact avec une surface intérieure du tube isolant.

L'entretoise comporte une gorge circulaire, une extrémité axiale du premier tube isolant étant reçue dans la gorge circulaire.

Une première entretoise et une deuxième entretoise sont disposées respectivement à chaque extrémité axiale du premier tube isolant.

L'entretoise est en polypropylène, ou tout autre matériau isolant électrique thermodurcissable, thermoplastique ou céramique. Eventuellement l'entretoise peut être en métal, en fonction des conditions diélectriques dans lesquelles se trouvent la cuve.

L'entretoise est configurée pour permettre un passage du gaz sous pression entre l'extérieur et l'intérieur du premier tube isolant.

La tige de renfort s'étend transversalement aux montants.

La tige de renfort est perpendiculaire aux montants.

La cuve comprend au moins deux faces planes opposées, la tige de renfort s'étend entre les montants solidaires des deux faces planes opposées de la cuve.

La tige de renfort relie les montants solidaires des panneaux de plus grande dimension de la cuve.

La cuve comprend deux montants parallèles définissant un plan perpendiculaire à au moins un panneau, et comprend deux tiges de renfort parallèles entre elles et s'étendant perpendiculairement aux deux montants. On entend ainsi que la cuve comprend au moins deux montants parallèles. La cuve peut comprendre un nombre supérieur de montants, en fonction du nombre et de la nature des équipements électriques contenus dans la cuve.

Selon un mode de réalisation, le premier tube isolant est entouré par une ailette en forme de disque.

Selon un autre mode de réalisation, une extrémité axiale du premier tube isolant est en contact avec une ailette en forme de disque.

Selon un exemple de mise en oeuvre de l'invention, chaque extrémité axiale du premier tube isolant est en contact avec une ailette en forme de disque.

L'ailette est électriquement isolante.

L'ailette est en polypropylène ou tout autre matériau isolant électrique thermodurcissable, thermoplastique, céramique ou élastomère.

L'ailette et le premier tube isolant sont coaxiaux.

L'ailette s'étend radialement dans un plan incliné par rapport à un axe longitudinal du premier tube isolant. L'ailette peut s'étendre dans un plan perpendiculaire à un axe longitudinal du premier tube isolant.

Une zone de contact entre le premier tube isolant et l'ailette s'étend de manière continue sur 360°.

Un diamètre extérieur de l'ailette est compris entre 15 et 150 millimètres.

Selon un mode de réalisation, l'entretoise et l'ailette forment un ensemble monobloc.

Le premier tube isolant est entouré par une ailette à chacune de ses extrémités.

L'ailette est adjacente au montant.

La distance entre l'ailette et le montant est comprise entre 1 et 30 millimètres.

Selon un mode de réalisation, le deuxième tube isolant est entouré par une ailette en forme de disque.

Une extrémité axiale du deuxième tube isolant est en contact avec une ailette en forme de disque.

La tige de renfort est liée aux montants de la structure par des écrous.

Selon un mode de réalisation, la liaison entre la tige de renfort et le montant de la structure comporte un contre-écrou, le montant étant comprimé entre l'écrou et le contre-écrou.

La tige de renfort est fixée aux montants par des rivets.

La tige de renfort est fixée aux montants par des éléments de liaison à emboitage élastique.

Les montants sont des profilés métalliques.

Les montants sont des profilés en forme de U.

L'écrou liant le montant et la tige de renfort est logé entre les ailes du U.

L'écrou liant le montant et la tige de renfort est en appui contre la base du U.

Selon un mode de réalisation de la cuve, une première paire de montants opposés sont reliés par au moins deux tiges de renfort et une deuxième paire de montants opposés sont reliés par au moins deux tiges de renfort.

Les au moins deux tiges de renfort sont parallèles.

La cuve comprend trois compartiments séparés, les tiges de renfort de la première paire de montant et les tiges de renfort de la deuxième paire de montant sont comprises dans un plan délimitant une séparation entre deux compartiments consécutifs.

### Brève description des dessins

D'autres caractéristiques, détails et avantages apparaîtront à la lecture de la description détaillée ci-après, et à l'analyse des dessins annexés, sur lesquels :
[Fig. 1] est une vue générale, en perspective, d'une cuve pour appareil électrique à moyenne tension selon l'invention,
[Fig. 2] est une vue partielle, de la cuve de la figure 1,
[Fig. 3] est une vue de détail illustrant deux montants de la cuve équipés d'au moins une tige de renfort,
[Fig. 4] est une vue de détail, en perspective, d'un premier mode de réalisation de l'invention,
[Fig. 5] est une vue de détail, en coupe, d'un deuxième mode de réalisation de l'invention,
[Fig. 6] est une vue de détail, en perspective, d'un troisième mode de réalisation de l'invention,
[Fig. 7] est une vue de détail, en coupe, d'un quatrième mode de réalisation de l'invention,
[Fig. 8] est une vue de détail, en coupe, du premier mode de réalisation de la figure 4,
[Fig. 9] est une autre vue de détail, en coupe, d'une variante du premier mode de réalisation de la figure 4,
[Fig. 10] est une vue de détail, en perspective, d'une entretoise du deuxième mode de réalisation de la figure 5,
[Fig. 11] est une vue de détail, en coupe, du troisième mode de réalisation de la figure 6,
[Fig. 12] est une vue de détail, en perspective, du quatrième mode de réalisation de la figure 7,
[Fig. 13] est une vue de détail, en coupe, d'une cinquième mode de réalisation.

### Description détaillée des modes de réalisation

Afin de faciliter la lecture des figures, les différents éléments ne sont pas nécessairement représentés à l'échelle. Sur ces figures, les éléments identiques portent les mêmes références. Certains éléments ou paramètres peuvent être indexés, c'est-à-dire désignés par exemple par premier élément ou deuxième élément, ou encore premier paramètre et second paramètre, etc. Cette indexation a pour but de différencier des éléments ou paramètres similaires, mais non identiques. Cette indexation n'implique pas une priorité d'un élément, ou paramètre par rapport à un autre et on peut interchanger les dénominations. Quand il est précisé qu'un sous-système comporte un élément donné, cela n'exclut pas la présence d'autres éléments dans ce sous-système.

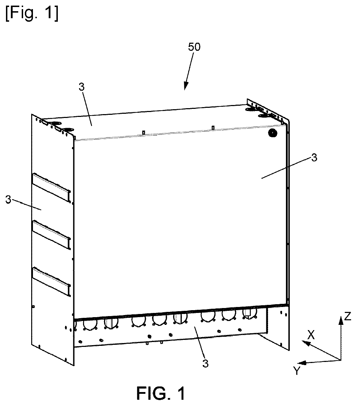

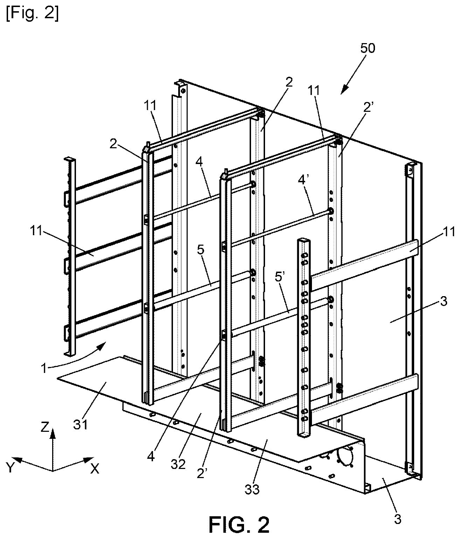

On a représenté sur la figure 1 et sur la figure 2 une cuve 50 pour appareil électrique à moyenne tension, destinée à contenir un gaz sous une pression supérieure à la pression atmosphérique, comportant :
- une structure 1 comportant des montants 2,
- des panneaux 3 solidaires des montants 2, les panneaux 3 étant configurés pour recevoir une force de pression du gaz sous pression.

L'ensemble des montants 2 fait partie d'une structure 1 sur laquelle des panneaux 3 sont fixés. Les panneaux 3 forment l'enveloppe extérieure de la cuve 50. Les panneaux 3 sont ici soudés sur la structure 1. Sur l'exemple illustré ici, la cuve 50 possède une forme générale de parallélépipède rectangle. La cuve 50 délimite un volume fermé délimité par les panneaux 3. Le volume défini par les panneaux 3 est étanche au gaz. Les montants 2 s'étendent selon une première direction Z correspondant à la direction verticale. Les montants 2 sont reliés à chacune de leur extrémité par des tirants 11, ou raidisseurs 11, qui s'étendent selon une deuxième direction X, transverse à la première direction Z et correspondant à une première direction horizontale. Une paire de montants 2 et une paire de raidisseurs 11 forment un cadre rectangulaire. Un panneau 3 peut être fixé sur chacun des côtés du cadre rectangulaire. Plusieurs cadres rectangulaires sont disposés le long de la troisième direction Y, correspondant à la deuxième direction horizontale et perpendiculaire à la première direction horizontale X. La structure 1 comprend l'ensemble des montants 2 et raidisseurs 11.

La cuve 50 peut ainsi contenir un gaz sous pression, c'est-à-dire à une pression supérieure à la pression atmosphérique. Le gaz destiné à être contenu dans la cuve peut être un gaz pur, où un mélange gazeux. Le gaz destiné à être contenu dans la cuve peut en particulier être un mélange binaire. Le gaz peut par exemple être de l'air sec ou déshumidifié, un mélange d'azote, d'oxygène et de dioxyde de carbone, ou tout autre gaz ou mélange possédant des propriétés d'isolation électrique adéquates. L'espace intérieur de la cuve 50 est destiné à recevoir des appareils électriques de distribution électrique de moyenne tension. On entend par le terme moyenne tension des tensions comprises entre 1 kilovolt (kV) et 52 kilovolts. Les appareils peuvent être par exemples des appareils de coupures tels que des interrupteurs, des interrupteurs-fusibles, des disjoncteurs ou des sectionneurs. En conditions nominales de fonctionnement, les appareils électriques sont au contact du gaz sous pression. La face intérieure des panneaux 3 est également au contact du gaz sous pression. La face extérieure des panneaux 3 est soumise à l'effet de la pression atmosphérique. Les forces engendrées par la différence de pression entre l'intérieur et l'extérieur de la cuve 50 ont ainsi tendance à écarter les panneaux. Les forces appliquées sur les panneaux sont transmises à la structure 1, en particulier aux montants 2, et tend à les faire fléchir.

La cuve 50 comporte en outre :
- au moins une tige métallique de renfort 4 s'étendant selon une direction longitudinale X, la tige de renfort 4 reliant entre eux deux montants 2 de façon à s'opposer à une déformation des montants 2 sous l'action de la force de pression du gaz,
- au moins un premier tube électriquement isolant 5,
dans laquelle au moins une portion longitudinale de la tige de renfort 4 est entourée par le premier tube isolant 5.

La tige de renfort 4 permet de rigidifier la structure 1 en limitant la flexion des montants 2 sous l'effet de la pression qui s'exerce sur les panneaux 3. En entourant la tige de renfort métallique 4 par un tube isolant 5, l'isolation électrique de la tige de renfort 4 est améliorée. Le risque d'avoir création d'un arc électrique entre la tige de renfort 4 et un appareil électrique disposé dans la cuve 50 est éliminé. La solution proposée permet ainsi d'assurer une résistance mécanique compatible avec les pressions mises en jeu dans la cuve, tout en garantissant une isolation électrique satisfaisante. Le surcout induit est faible et modifie peu le procédé de fabrication de la cuve. Ainsi, une cuve initialement conçue pour être remplie de gaz fluoré sous pression peut être adaptée pour fonctionner avec un gaz non fluoré comme l'air ou l'azote, demandant une pression supérieure, avec un nombre limité de modifications.

La tige de renfort 4 est disposée, sur au moins une partie de sa longueur, à l'intérieur du premier tube isolant 5. Les extrémités de la tige de renfort 4 sont à l'extérieur du volume délimité par le premier tube isolant 5.

La portion longitudinale entourée par le premier tube isolant 5 est disposée entre les deux montants 2. La tige de renfort 4 comprend une portion longitudinalement centrale 25 et deux portions d'extrémité 26, 27 situées de part et d'autre de la portion centrale. Chaque montant 2 est disposé entre la portion centrale 25 et une portion d'extrémité respective.

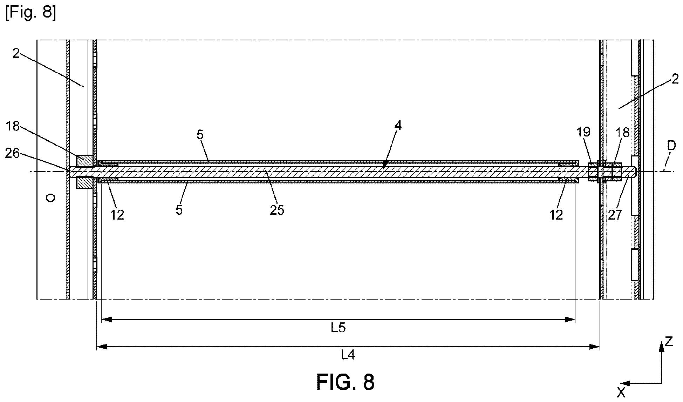

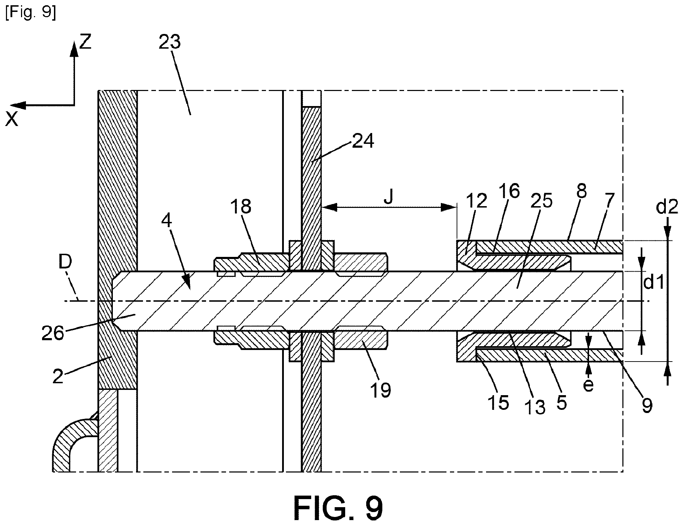

Comme détaillé sur la figure 8 et la figure 9, la tige de renfort 4 et le premier tube isolant 5 sont coaxiaux. La tige de renfort 4 et le premier tube isolant 5 s'étendent selon un axe commun D. L'axe D est parallèle à la direction longitudinale X.

Le premier tube isolant 5 est disposé, selon la direction longitudinale X, entre les deux montants 2.

Une surface intérieure 7 du premier tube isolant 5 est distante d'une surface latérale 9 de la tige de renfort 4. Autrement dit, il existe un jeu radial entre la tige de renfort 4 et le premier tube isolant 5. Le fait d'avoir un jeu radial permet de réduire le champ électrique à la surface extérieure 8 du tube isolant 5. Le risque d'avoir une décharge électrique se propageant sur la surface extérieure 8 du tube isolant 5 est ainsi réduit.

Selon l'exemple illustré, notamment sur la figure 9, une surface intérieure 7 du premier tube isolant 5 est en vis-à-vis de la tige de renfort 4. Plus précisément, une surface intérieure 7 du premier tube isolant 5 est séparée de la surface latérale 9 de la tige de renfort 4 par du gaz sous pression.

La tige de renfort 4 et le premier tube isolant 5 sont configurés pour qu'une pression du gaz à l'intérieur du premier tube isolant 5 soit égale à une pression du gaz à l'extérieur du tube isolant 5.

Selon un mode de réalisation non représenté, le premier tube isolant 5 est rempli d'une mousse isolante. La mousse isolante peut être par exemple du polyuréthane, de l'époxy, ou du silicone. Autrement dit, l'espace radialement compris entre le premier tube isolant 5 et la tige de renfort 4 est rempli par une mousse isolante. La mousse isolante est en contact avec la tige de renfort 4 ainsi qu'avec la surface intérieure du premier tube isolant.

La tige de renfort 4 est rectiligne. La tige de renfort 4 est cylindrique. Le diamètre d1 de la tige de renfort 4 est compris entre 6 et 20 millimètres.

La tige de renfort 4 est liée aux montants 2 de la structure 1 par des écrous 18. Un écrou 18 est disposé à chacune des extrémités 25, 26 de la tige de renfort 4.

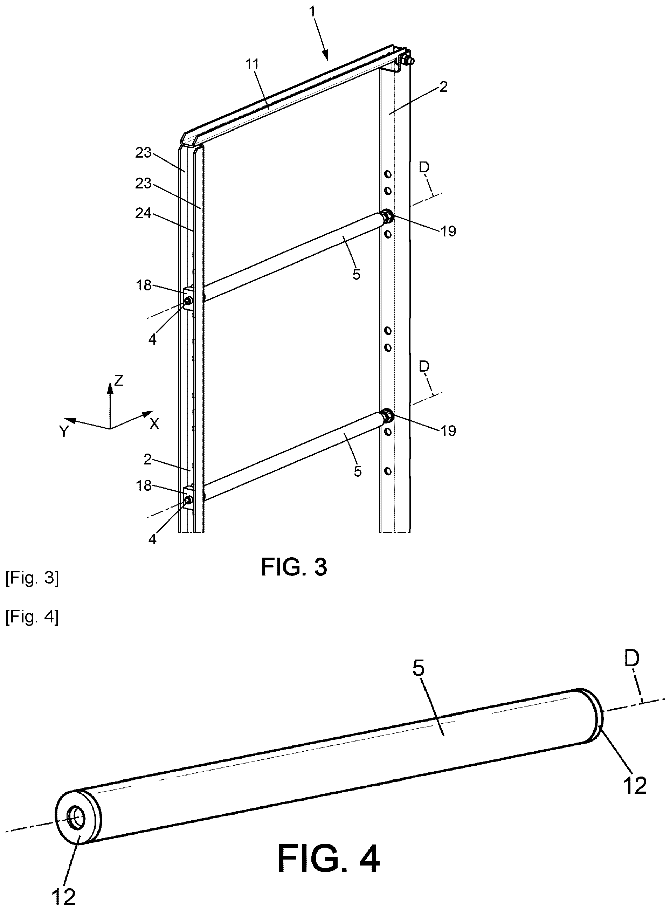

Comme détaillé sur la figure 8 et sur la figure 3, la liaison entre la tige de renfort 4 et le montant 2 de la structure 1 comporte un contre-écrou 19, le montant 2 étant comprimé entre l'écrou 18 et le contre-écrou 19. L'effet de la force de pression agissant sur les panneaux 3, et transmise aux montants, fait travailler la tige de renfort 4 en élongation.

Comme détaillé sur la figure 3, les montants 2 sont des profilés métalliques. Sur l'exemple ici décrit, les montants 2 sont des profilés en forme de U. On entend par là qu'une section transversale du profilé à la forme d'un U. Ainsi, les montants 2 comportent deux ailes 23, parallèles et en vis-à-vis, reliées entre elles par une base 24. L'écrou 18 liant le montant 2 et la tige de renfort 4 est logé entre les ailes 23 du U. L'écrou 18 liant le montant 2 et la tige de renfort 4 est en appui contre la base 24 du U. Une première paire de montants 2 opposés sont reliés par au moins deux tiges de renfort 4 et une deuxième paire de montants 2' opposés sont reliés par au moins deux tiges de renfort 4' . Les au moins deux tiges de renfort 4, 4' sont parallèles.

Sur l'exemple illustré, et représenté sur la figure 2, la cuve 50 comprend trois compartiments 31, 32, 33. Les tiges de renfort 4 de la première paire de montant 2 et les tiges de renfort 4' de la deuxième paire de montant 2' sont comprises dans un plan délimitant deux compartiments consécutifs. On entend par compartiments consécutifs des compartiments voisins, c'est-à-dire accolés les uns aux autres. Les tiges de renfort 4 de la première paire de montant 2 délimitent le premier compartiment 31 du deuxième compartiment 32. Les tiges de renfort 4' de la deuxième paire de montant 2' délimitent le deuxième compartiment 32 du troisième compartiment 33. Des appareils électriques, non représentés, sont disposés dans les différents compartiments 31, 32, 33.

La tige de renfort 4 s'étend transversalement aux montants 2. Dans l'exemple représenté sur la figure 2 et sur la figure 3, la tige de renfort 4 est perpendiculaire aux montants 2.

La cuve 50 comprend au moins deux faces planes opposées, la tige de renfort 4 s'étend entre les montants 2 solidaires des deux faces planes opposées de la cuve. La tige de renfort relie les montants 2 solidaires des panneaux 3 de plus grande dimension de la cuve 50. Sur la figure 2, les panneaux latéraux ainsi que le panneau avant n'ont pas été représentés, afin de montrer la structure 1 de la cuve 50.

La cuve 50 comprend deux montants 2 parallèles définissant un plan perpendiculaire à au moins un panneau 3, et comprend deux tiges de renfort 4 parallèles entre elles et s'étendant perpendiculairement aux deux montants 2. Sur la figure 2, le premier tube isolant entourant la tige de renfort supérieure n'a pas été représenté afin de montrer la tige de renfort 4. Le premier tube isolant 5 est représenté au niveau de la tige de renfort inférieure, ce qui fait que seule la portion d'extrémité de la tige de renfort 4 inférieure dépassant du montant 2 est visible.

Selon une variante de mise en œuvre, la tige de renfort 4 est une tige filetée. Autrement dit, la tige de renfort 4 est filetée sur toute sa longueur. Selon une autre variante, la tige de renfort 4 est filetée au niveau d'une première portion d'extrémité 26 et au niveau d'une deuxième portion d'extrémité 27, et est lisse au niveau d'une portion centrale 25 comprise entre les deux portions d'extrémités 26, 27. Plus particulièrement, la portion de la tige de renfort 4 située en vis-à-vis du premier tube isolant 4 peut être lisse. Autrement dit ; la portion de la tige de renfort 4 entourée par le premier tube isolant 5 peut être lisse.

Le premier tube isolant 5 est cylindrique. Le premier tube isolant 5 est ici en polypropylène. Le premier tube isolant 5 peut également être en matériau isolant thermodurcissable, thermoplastique ou céramique. Ces matériaux procurent de bonnes propriétés d'isolation électrique.

Un diamètre externe d2 du premier tube isolant 5 est compris entre 10 et 24 millimètres. Une épaisseur e du premier tube isolant 5 est comprise entre 1 et 6 millimètres.

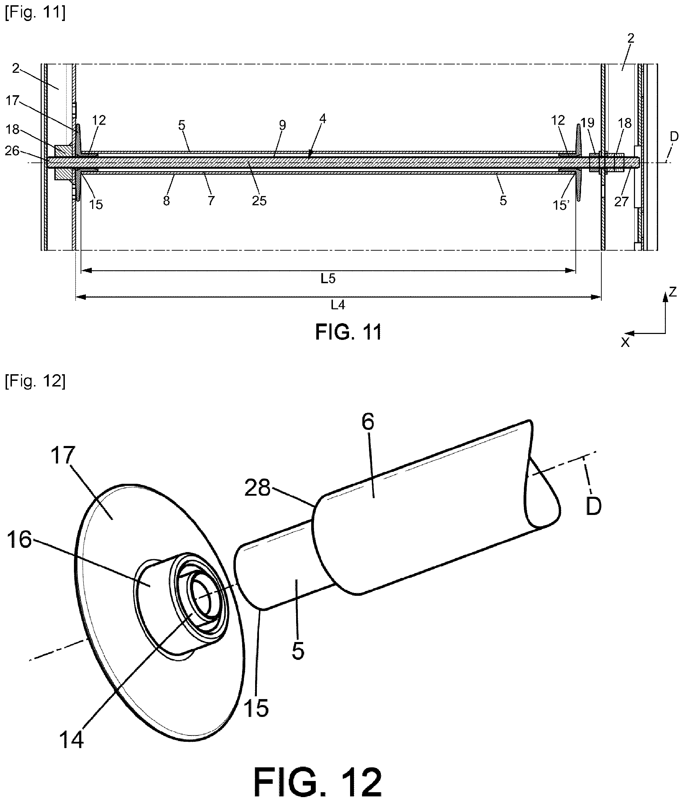

Comme représenté sur la figure 8 et sur la figure 11, une longueur L5 du premier tube isolant 5 est supérieure à 80% d'une distance L4 entre les 2 montants.

Un rapport entre le diamètre d1 de la tige de renfort 4 et le diamètre externe d2 du premier tube isolant 5 est compris entre 0,1 et 0,6.

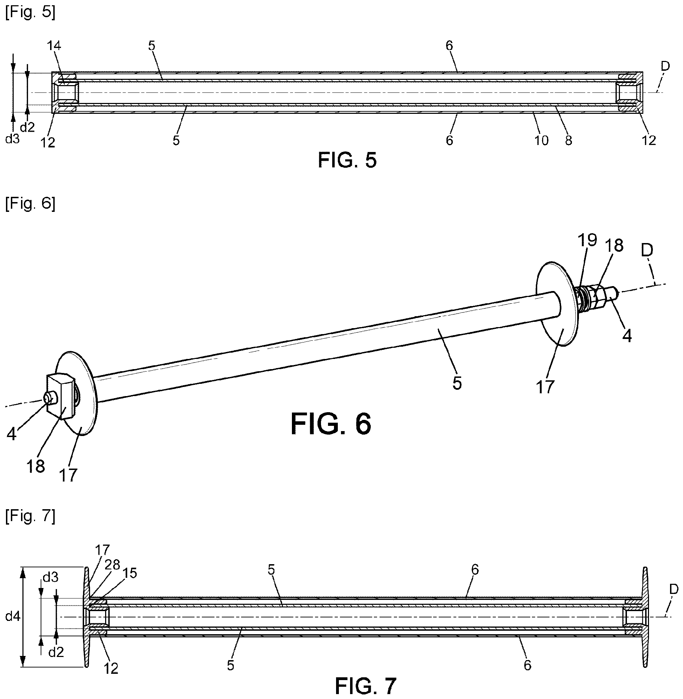

Selon un deuxième mode de réalisation, illustré sur la figure 5, la cuve 50 comprend un deuxième tube isolant 6, et le deuxième tube isolant 6 entoure le premier tube isolant 5. Sur les figures 4, 5, 7, la tige de renfort 4 n'a pas été représentée. Autrement dit, le deuxième mode de réalisation diffère du premier mode par l'ajout d'un deuxième tube isolant. Ceci permet d'éviter l'apparition d'un arc ou une décharge électrique entre la surface du deuxième tube isolant 6 et la tige de renfort 4.

Sur l'exemple représenté sur la figure 5, le deuxième tube isolant 6 et le premier tube isolant 5 sont coaxiaux. Autrement dit, le premier tube isolant 5 est disposé à l'intérieur du deuxième tube isolant 6. Le deuxième tube isolant 6 entoure le premier tube isolant 5 sur toute la longueur du premier tube isolant 5. Sur l'exemple représenté sur la figure 5, le deuxième tube isolant 6 et le premier tube isolant 5 ont la même longueur.

Un diamètre externe D3 du deuxième tube isolant 6 est compris entre 14 et 40 millimètres.

Une surface intérieure 10 du deuxième tube isolant 6 est distante d'une surface extérieure 8 du premier tube isolant 5. Autrement dit, il existe un jeu radial entre le premier tube isolant 5 et le deuxième tube isolant 6. Ce jeu radial permet de réduire encore davantage le champ électrique.

La surface intérieure 10 du deuxième tube isolant 6 est séparée de la surface extérieure 8 du premier tube isolant 5 par une couche de gaz sous pression. La pression à l'intérieur du premier tube isolant 5 et la pression à l'intérieur du deuxième tube isolant 6 sont identiques. Cette pression est égale à la pression à l'intérieur de la cuve.

La cuve 50 comporte une entretoise 12 configurée pour maintenir le premier tube isolant 5 coaxial avec la tige de renfort 4.

L'entretoise 12 comporte un logement débouchant 13 recevant la tige de renfort 4. La tige de renfort 4 traverse l'entretoise 12 selon la direction longitudinale X, qui est aussi la direction de l'axe D du tube isolant 5.

L'entretoise 12 comporte une zone de réception insérée au moins en partie dans le premier tube isolant 5. Une portion de l'entretoise 12 est ainsi intercalée radialement entre la tige de renfort 4 et le premier tube isolant 5. L'entretoise 12 maintient ainsi le tube 5.

L'entretoise 12 est en polypropylène. L'entretoise 12 peut également être dans tout autre matériau isolant électrique thermodurcissable, thermoplastique, céramique ou en métal.

L'entretoise 12 est configurée pour permettre un passage du gaz sous pression entre l'extérieur et l'intérieur du tube isolant 5. Autrement dit, l'entretoise 12 n'assure pas une fermeture étanche du premier tube isolant 5.

Dans le deuxième mode de réalisation représenté sur la figure 5, la cuve 50 comporte une entretoise 12 configurée pour maintenir le premier tube isolant 5 coaxial avec la tige de renfort 4 et pour maintenir le deuxième tube isolant 6 coaxial avec la tige de renfort 4. A chacune des extrémités, une entretoise 12 unique permet de maintenir le premier tube isolant 5 et le deuxième tube isolant 6. Autrement dit, à chaque extrémité la même entretoise maintient le premier tube isolant 5 et le deuxième tube isolant 6.

L'entretoise 12 est disposée à une extrémité axiale du premier tube isolant 5. Dans le deuxième et la quatrième mode de réalisation, dans lesquels un deuxième tube isolant 6 entoure le premier tube isolant 5, une entretoise 12 est disposée à une extrémité axiale du deuxième tube isolant 6. Plus précisément, une entretoise 12 est disposée à chaque extrémité axiale du deuxième tube isolant 6.

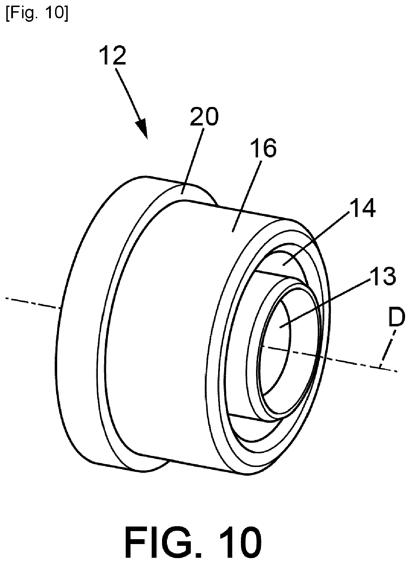

La figure 10 détaille plus particulièrement l'entretoise 12 du deuxième mode de réalisation. L'entretoise 12 est en forme de bague cylindrique épaulée. Une extrémité axiale 28 du deuxième tube isolant 6 est en contact avec un épaulement 20 de l'entretoise 12.

Comme représenté notamment sur la figure 9, une surface interne de la bague épaulée est en contact avec la tige de renfort 4 et une surface externe 16 de la bague est en contact avec une surface intérieure 7 du tube isolant 5.

Dans le deuxième mode de réalisation et le quatrième mode de réalisation, qui comprennent deux tubes isolants 5, 6 tel que décrit précédemment, l'entretoise 12 comporte une gorge circulaire 14, une extrémité axiale 15 du premier tube isolant 5 étant reçue dans la gorge circulaire 14. La figure 12 met en évidence cette caractéristique. Dans ces modes de réalisation, le deuxième tube isolant 6 est maintenu par l'entretoise 12 de la même manière que le premier tube isolant 5 dans le premier et le troisième mode de réalisation.

Une première entretoise 12 et une deuxième entretoise 12' sont disposées respectivement à chaque extrémité axiale 15, 15' du tube isolant 5.

Selon une caractéristique de l'invention, un jeu axial J est présent entre une entretoise 12 et le montant 2 traversé par l'extrémité axiale correspondante de la tige de renfort.

Le troisième mode de réalisation et le cinquième mode de réalisation diffèrent du premier mode de réalisation par l'ajout d'une ailette 17 sur le premier tube isolant 5, ou à son voisinage immédiat. Le quatrième mode de réalisation diffère du deuxième mode de réalisation par l'ajout d'une ailette 17 au deuxième tube isolant 6.

L'ailette 17 est électriquement isolante. L'ailette 17 est par exemple en polypropylène, ou tout autre matériau isolant électrique thermodurcissable, thermoplastique, élastomère ou céramique. L'ailette 17 et le tube isolant 5 sont coaxiaux. L'ailette 17 s'étend radialement dans un plan incliné par rapport à un axe longitudinal D du premier tube isolant 5. Dans l'exemple illustré, l'ailette 17 s'étend radialement dans un plan perpendiculaire à l'axe longitudinal D du premier tube isolant 5. Un diamètre extérieur D4 de l'ailette 17 est compris entre 15 et 150 millimètres. L'ailette 17 permet d'améliorer l'isolation électrique du sous-ensemble formé par la tige de renfort 4, les entretoises 12 et le ou les tubes isolants 5, 6. En effet, la présence de l'ailette 17 augmente la longueur du trajet qu'un éventuel arc électrique ou décharge électrique doit accomplir pour passer d'un composant électrique à un potentiel électrique de l'appareil électrique contenu dans la cuve 50 à tout élément de la cuve à la masse, en se propageant le long de l'extérieur du tube isolant le plus éloigné de la tige de renfort 4.

Comme illustré sur les figures 6 et 12, pour le troisième et le quatrième mode de réalisation, une extrémité axiale 15 du premier tube isolant 5 est en contact avec une ailette 17 en forme de disque. Plus précisément, chaque extrémité axiale 15, 15' du premier tube isolant 5 est en contact avec une ailette 17 en forme de disque.

Comme illustré sur la figure 7 et la figure 12, une extrémité axiale 28 du deuxième tube isolant 6 est en contact avec une ailette 17 en forme de disque.

Selon l'exemple illustré notamment sur les figures 6 et 12, l'entretoise 12 et l'ailette 17 forment un ensemble monobloc. L'ensemble peut être obtenu par injection plastique. Les ailettes peuvent comprendre des protubérances, non représentées, visant à allonger la trajectoire de ligne de fuite que devrait parcourir un arc électrique.

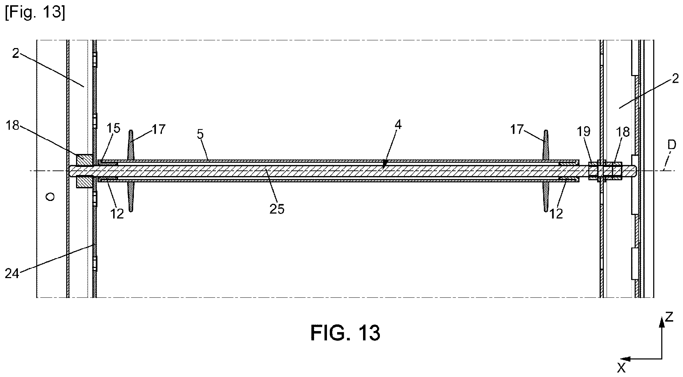

Selon un cinquième mode de réalisation, représenté sur la figure 13, le premier tube isolant 5 est entouré par une ailette isolante 17 en forme de disque. Autrement dit, une portion du premier tube isolant 5 s'étend selon la direction longitudinale X de part de d'autre de l'ailette isolante 17.

L'ailette isolante 17 est distante de l'extrémité axiale 15 du premier tube isolant 5. Une zone de contact entre la surface extérieure du premier tube isolant 5 et l'ailette 17 s'étend de manière continue sur 360°. De plus, la zone de contact entre le premier tube isolant 5 et l'ailette 17 est étanche. L'ailette isolante 17 peut par exemple faire partie intégrante du tube isolant. Autrement dit, l'ailette isolante et le tube isolant peuvent former un ensemble monobloc. L'ailette isolante 17 peut aussi être rapportée sur la périphérie du premier tube isolant 5.

Le tube isolant 5 est entouré par une ailette 17 au voisinage de chacune de ses extrémités. Des ailettes supplémentaires similaires peuvent être ajoutées le long du tube isolant.

Selon le troisième mode de réalisation représenté sur la figure 11, une ailette 17 est adjacente au montant 2. La distance entre l'ailette 17 et le montant 2 est comprise entre 1 et 30 millimètres.

Selon des modes de réalisation non représentés :
- Le deuxième tube isolant 6 peut être entouré par une ailette 17 en forme de disque. Ce mode de réalisation est analogue au cinquième mode de réalisation, et l'ailette 17 entoure le tube le plus éloigné de la tige 4, par conséquent le deuxième tube isolant 6.
- La tige de renfort 4 peut être fixée aux montants par des rivets.
- La tige de renfort 4 peut être fixée aux montants par des éléments de liaison à emboitage élastique.
- Lorsque l'espace compris radialement entre le premier tube isolant 5 et la tige de renfort 4 est rempli de mousse isolante, le premier tube isolant 5 peut être maintenu à distance de la tige de renfort 4 par la mousse isolante.
- La cuve 50 peut comporter deux compartiments délimités par une ou plusieurs tiges de renfort. La cuve 50 peut aussi comporter plus de trois compartiments, délimités par une ou plusieurs tiges de renfort.

## Revendications

1. Cuve (50) pour appareil électrique à moyenne tension, destinée à contenir un gaz sous une pression supérieure à la pression atmosphérique, comportant :
- une structure (1) comportant des montants (2),
- des panneaux (3) solidaires des montants (2), les panneaux (3) étant configurés pour recevoir une force de pression du gaz sous pression,
- au moins une tige métallique de renfort (4) s'étendant selon une direction longitudinale (X), la tige de renfort (4) reliant entre eux deux montants (2) de façon à s'opposer à une déformation des montants (2) sous l'action de la force de pression du gaz,
**caractérisée en ce qu'**elle comprend au moins un premier tube électriquement isolant (5),
dans laquelle au moins une portion longitudinale de la tige de renfort (4) est entourée par le premier tube isolant (5) et dans laquelle une surface intérieure (7) du premier tube isolant (5) est distante d'une surface latérale (9) de la tige de renfort (4).

2. Cuve selon la revendication 1, dans laquelle la tige de renfort (4) et le premier tube isolant (5) sont coaxiaux.

3. Cuve selon la revendication 1 ou 2, dans laquelle le premier tube isolant (5) est disposé, selon la direction longitudinale (X), entre les deux montants (2).

4. Cuve selon l'une des revendications précédentes, dans laquelle la cuve est configurée de sorte qu'une surface intérieure (7) du premier tube isolant (5) est séparée de la surface latérale (9) de la tige de renfort (4) par le gaz sous pression.

5. Cuve selon l'une des revendications 1 à 3, dans laquelle le premier tube isolant (5) est rempli d'une mousse isolante.

6. Cuve selon l'une des revendications précédentes, dans laquelle un rapport entre le diamètre (d1) de la tige de renfort (4) et le diamètre externe (d2) du premier tube isolant (5) est compris entre 0,1 et 0,6.

7. Cuve selon l'une des revendications précédentes, comportant une entretoise (12) configurée pour maintenir le premier tube isolant (5) coaxial avec la tige de renfort (4).

8. Cuve selon l'une des revendications précédentes, comprenant un deuxième tube isolant (6), dans laquelle le deuxième tube isolant (6) entoure le premier tube isolant (5), dans laquelle le deuxième tube isolant (6) et le premier tube isolant (5) sont coaxiaux, et dans laquelle une surface intérieure (10) du deuxième tube isolant (6) est distante d'une surface extérieure (8) du premier tube isolant (5).

9. Cuve selon la revendication précédente, dans laquelle la surface intérieure (10) du deuxième tube isolant (6) est séparée de la surface extérieure (8) du premier tube isolant (5) par du gaz sous pression.

10. Cuve selon l'une des revendications 1 à 7, dans laquelle le premier tube isolant (5) est entouré par une ailette isolante (17) en forme de disque, l'ailette isolante (17) s'étendant radialement dans un plan incliné par rapport à un axe longitudinal (D) du premier tube isolant (5).

11. Cuve selon l'une des revendications 1 à 7, dans laquelle une extrémité axiale (15) du premier tube isolant (5) est en contact avec une ailette isolante (17) en forme de disque, l'ailette isolante (17) s'étendant radialement dans un plan incliné par rapport à un axe longitudinal (D) du premier tube isolant (5).

12. Cuve selon la revendication précédente, dans laquelle chaque extrémité axiale (15, 15') du premier tube isolant (5) est en contact avec une ailette isolante (17) en forme de disque.

13. Cuve selon la revendication 11 ou 12, comportant une entretoise (12) configurée pour maintenir le premier tube isolant (5) coaxial avec la tige de renfort (4) et pour maintenir le deuxième tube isolant (6) coaxial avec la tige de renfort (4), dans laquelle l'entretoise (12) et l'ailette (17) forment un ensemble monobloc.

14. Cuve selon l'une des revendications précédentes, dans laquelle la tige de renfort (4) est liée aux montants (2) de la structure (1) par des écrous (18).

## Patentansprüche

1. Behälter (50) für elektrisches Mittelspannungsgerät, der dazu bestimmt ist, ein Gas mit einem Druck größer als der Atmosphärendruck zu enthalten, aufweisend:
- eine Struktur (1) mit Holmen (2),
- Paneele (3), die mit den Holmen (2) fest verbunden sind, wobei die Paneele (3) dazu ausgebildet sind, eine Druckkraft des unter Druck stehenden Gases aufzunehmen,
- wenigstens eine metallische Verstärkungsstange (4), die sich in einer Längsrichtung (X) erstreckt, wobei die Verstärkungsstange (4) zwei Holme (2) miteinander verbindet, um einer Verformung der Holme (2) unter der Einwirkung der Druckkraft des Gases entgegenzuwirken,
**dadurch gekennzeichnet, dass** er wenigstens ein erstes elektrisch isolierendes Rohr (5) umfasst, wobei wenigstens ein Längsabschnitt der Verstärkungsstange (4) von dem ersten isolierenden Rohr (5) umgeben ist und wobei eine Innenfläche (7) des ersten isolierenden Rohrs (5) von einer Seitenfläche (9) der Verstärkungsstange (4) beabstandet ist.

2. Behälter nach Anspruch 1, wobei die Verstärkungsstange (4) und das erste isolierende Rohr (5) koaxial sind.

3. Behälter nach Anspruch 1 oder 2, wobei das erste isolierende Rohr (5) in der Längsrichtung (X) zwischen den zwei Holmen (2) angeordnet ist.

4. Behälter nach einem der vorhergehenden Ansprüche, wobei der Behälter so ausgebildet ist, dass eine Innenfläche (7) des ersten isolierenden Rohrs (5) durch das unter Druck stehende Gas von der Seitenfläche (9) der Verstärkungsstange (4) getrennt ist.

5. Behälter nach einem der Ansprüche 1 bis 3, wobei das erste isolierende Rohr (5) mit einem Isolierschaum gefüllt ist.

6. Behälter nach einem der vorhergehenden Ansprüche, wobei ein Verhältnis zwischen dem Durchmesser (d1) der Verstärkungsstange (4) und dem Außendurchmesser (d2) des ersten isolierenden Rohrs (5) zwischen 0,1 und 0,6 beträgt.

7. Behälter nach einem der vorhergehenden Ansprüche, aufweisend einen Abstandshalter (12), der dazu ausgebildet ist, das erste isolierende Rohr (5) zur Verstärkungsstange (4) koaxial zu halten.

8. Behälter nach einem der vorhergehenden Ansprüche, umfassend ein zweites isolierendes Rohr (6), wobei das zweite isolierende Rohr (6) das erste isolierende Rohr (5) umgibt, wobei das zweite isolierende Rohr (6) und das erste isolierende Rohr (5) koaxial sind, und wobei eine Innenfläche (10) des zweiten isolierenden Rohrs (6) von einer Außenfläche (8) des ersten isolierenden Rohrs (5) beabstandet ist.

9. Behälter nach dem vorhergehenden Anspruch, wobei die Innenfläche (10) des zweiten isolierenden Rohrs (6) durch unter Druck stehendes Gas von der Außenfläche (8) des ersten isolierenden Rohrs (5) getrennt ist.

10. Behälter nach einem der Ansprüche 1 bis 7, wobei das erste isolierende Rohr (5) von einer scheibenförmigen Isolierrippe (17) umgeben ist, wobei sich die Isolierrippe (17) radial in einer Ebene erstreckt, die im Verhältnis zu einer Längsachse (D) des ersten isolierenden Rohrs (5) geneigt ist.

11. Behälter nach einem der Ansprüche 1 bis 7, wobei ein Axialende (15) des ersten isolierenden Rohrs (5) mit einer scheibenförmigen Isolierrippe (17) in Kontakt steht, wobei sich die Isolierrippe (17) radial in einer Ebene erstreckt, die im Verhältnis zu einer Längsachse (D) des ersten isolierenden Rohrs (5) geneigt ist.

12. Behälter nach dem vorhergehenden Anspruch, wobei jedes Axialende (15, 15') des ersten isolierenden Rohrs (5) mit einer scheibenförmigen Isolierrippe (17) in Kontakt steht.

13. Behälter nach Anspruch 11 oder 12, aufweisend einen Abstandshalter (12), der dazu ausgebildet ist, das erste isolierende Rohr (5) koaxial zur Verstärkungsstange (4) zu halten und das zweite isolierende Rohr (6) koaxial zur Verstärkungsstange (4) zu halten, wobei der Abstandshalter (12) und die Rippe (17) eine einstückige Einheit bilden.

14. Behälter nach einem der vorhergehenden Ansprüche, wobei die Verstärkungsstange (4) durch Muttern (18) mit den Holmen (2) der Struktur (1) verbunden ist.

## Claims

1. Tank (50) for a medium-voltage electrical unit that is intended to contain a gas under a pressure greater than atmospheric pressure, said tank having:
- a structure (1) that has uprights (2),
- panels (3) that are secured to the uprights (2), the panels (3) being configured to receive a pressure force of the pressurized gas,
- at least one metal reinforcing rod (4) extending in a longitudinal direction (X), the reinforcing rod (4) connecting together two uprights (2) so as to counter a deformation of the uprights (2) under the action of the pressure force of the gas, **characterized in that** it comprises
- at least one first electrically insulating tube (5),
wherein at least one longitudinal portion of the reinforcing rod (4) is surrounded by the first insulating tube (5), and wherein an inner surface (7) of the first insulating tube (5) is spaced apart from a lateral surface (9) of the reinforcing rod (4).

2. Tank according to Claim 1, wherein the reinforcing rod (4) and the first insulating tube (5) are coaxial.

3. Tank according to Claim 1 or 2, wherein the first insulating tube (5) is disposed between the two uprights (2) in the longitudinal direction (X).

4. Tank according to one of the preceding claims, wherein the tank is configured such that an inner surface (7) of the first insulating tube (5) is separated from the lateral surface (9) of the reinforcing rod (4) by the pressurized gas.

5. Tank according to one of Claims 1 to 3, wherein the first insulating tube (5) is filled with an insulating foam.

6. Tank according to one of the preceding claims, wherein a ratio between the diameter (d1) of the reinforcing rod (4) and the external diameter (d2) of the first insulating tube (5) is between 0.1 and 0.6.

7. Tank according to one of the preceding claims, having a spacer (12) configured to hold the first insulating tube (5) in place coaxially with the reinforcing rod (4).

8. Tank according to one of the preceding claims, comprising a second insulating tube (6), wherein the second insulating tube (6) surrounds the first insulating tube (5), wherein the second insulating tube (6) and the first insulating tube (5) are coaxial, and wherein an inner surface (10) of the second insulating tube (6) is spaced apart from an outer surface (8) of the first insulating tube (5).

9. Tank according to the preceding claim, wherein the inner surface (10) of the second insulating tube (6) is separated from the outer surface (8) of the first insulating tube (5) by the pressurized gas.

10. Tank according to one of Claims 1 to 7, wherein the first insulating tube (5) is surrounded by an insulating disc-shaped splitter (17), the insulating splitter (17) extending radially in a plane inclined with respect to a longitudinal axis (D) of the first insulating tube (5).

11. Tank according to one of Claims 1 to 7, wherein one axial end (15) of the first insulating tube (5) is in contact with an insulating disc-shaped splitter (17), the insulating splitter (17) extending radially in a plane inclined with respect to a longitudinal axis (D) of the first insulating tube (5).

12. Tank according to the preceding claim, wherein each axial end (15, 15') of the first insulating tube (5) is in contact with an insulating disc-shaped splitter (17).

13. Tank according to Claim 11 or 12, having a spacer (12) configured to hold the first insulating tube (5) in place coaxially with the reinforcing rod (4) and to hold the second insulating tube (6) in place coaxially with the reinforcing rod (4), wherein the spacer (12) and the splitter (17) form a one-piece assembly.

14. Tank according to one of the preceding claims, wherein the reinforcing rod (4) is connected to the uprights (2) of the structure (1) by nuts (18).
